# DEMANDE DE BREVET EUROPEEN

(11) **EP 3 792 958 A1**
(43) Date de publication de la demande: **17.03.2021**
(21) Numéro de dépôt: 20195682.8
(22) Date de dépôt: 11.09.2020
(51) Int. Cl.: H01L 21/306, H01L 21/316

(54) **PROCÉDÉ DE GRAVURE D'UNE COUCHE À BASE D'UN MATÉRIAU III-V**

(30) Priorité: 12.09.2019 FR 1910110
(71) Demandeur: Commissariat à l'Energie Atomique et aux Energies Alternatives, 75015 Paris (FR)
(72) Inventeur: POSSEME, Nicolas, 38054 GRENOBLE Cedex 9 (FR); LE ROUX, Frédéric, 38054 GRENOBLE Cedex 09 (FR)
(74) Mandataire: Hautier, Nicolas

(57) **Abrégé**

Procédé de gravure d'une couche à base d'un matériau III-V L'invention concerne notamment un procédé de gravure d'au moins une couche (100) à base d'un matériau III-V (100), le procédé comprenant au moins :
- fournir au moins ladite couche (100),
- au moins un cycle comprenant au moins les étapes suivantes:
∘ modifier, par implantation (10) d'ions à base d'hydrogène (H) et/ou d'hélium (He), une partie au moins de l'épaisseur (e100) de ladite couche (100) pour former dans ladite couche (100) au moins une portion modifiée (110),
∘ oxyder une partie au moins de la portion modifiée (110) en exposant ladite couche (100) à un plasma (20) à base d'oxygène, pour définir dans ladite couche (100) au moins une portion oxydée (120) et au moins une portion non oxydée,
∘ graver l'au moins une portion oxydée (120) sélectivement à l'au moins une portion non oxydée

## Description

### DOMAINE TECHNIQUE

La présente invention concerne en général l'intégration de couches à base de matériaux III-V et notamment à base de matériaux III-N tels que le nitrure de gallium (GaN) au sein de dispositifs micro-électroniques. Elle trouvera pour application avantageuse la réalisation de dispositifs tels que des transistors intégrant une ou plusieurs couches de matériaux III-N.

### ÉTAT DE LA TECHNIQUE

La chasse au gaspillage énergétique et l'augmentation des besoins poussent les fabricants de dispositifs microélectroniques à améliorer les rendements et les performances de leurs systèmes de conversion de l'énergie électrique. Actuellement, les circuits de conversion sont fabriqués à base de silicium et de nombreuses recherches ont été menées pour faire évoluer les architectures dans le but de gagner en rendement et en conductivité. Néanmoins, ces dispositifs connus arrivent aux limites théoriques du silicium et de nouvelles solutions doivent être développées.

Grâce à ses propriétés électriques permettant la formation d'un gaz d'électrons bi-dimensionnel, l'hétérostructure AlGaN/GaN, formée d'une couche de nitrure d'aluminium-galium sur une couche de nitrure de galium, présente de bonnes perspectives pour le développement de l'électronique de puissance. Il concurrence le Si et le SiC en termes de taille de dispositif, de tenue en tension, de mobilité de porteurs ainsi que de résistance en série.

Néanmoins, l'utilisation pratique de cette hétérostructure AlGaN/GaN par exemple dans un transistor ou une diode pose des problématiques fortes qu'il convient de résoudre afin d'exploiter toutes les performances de ces matériaux à base de GaN. Plus généralement, ces problématiques se posent pour les matériaux III-V et en particulier les matériaux III-N. Il a été notamment identifié que les étapes de gravure, pour les structurations des dispositifs, sont critiques et dégradent les propriétés électriques du canal.

Ces étapes de gravure concernent par exemple l'ouverture d'une couche de passivation surmontant l'hétérostructure AlGaN/GaN afin de former les contacts d'une diode ou de former la grille ou les contacts pour les transistors, par exemple des transistors HEMT (acronyme anglais de « High Electron Mobility Transistor »).

Ces étapes s'effectuent par gravure plasma traditionnelle avec des chimies chlorées, dans un réacteur plasma à couplage inductif (ICP).

Ces solutions présentent de nombreux inconvénients. En particulier le bombardement ionique lors de la gravure plasma entraine généralement une dégradation des matériaux des couches et motifs que l'on souhaite conserver. Par ailleurs, le contrôle de la profondeur de gravure, effectué au temps en l'absence de couche d'arrêt, est peu précis.

Tous ces inconvénients conduisent à dégrader la couche d'AlGaN et à réduire les performances du dispositif.

Des techniques par gravure cycliques ont été proposées pour limiter ces inconvénients. Ce type de technique a été décrit dans le document brevet US8124505B1 publié le 28 Février 2012. Comme indiqué dans ce document, la gravure cyclique de GaN est constituée des deux étapes suivantes:
une première étape d'oxydation par un plasma d'oxygène. Dans ce cas la zone oxydée est de 1-3nm.
une deuxième étape de gravure de l'oxyde crée sélectivement au GaN non modifié par un plasma à base de BCl₃.

Si cette technique permet d'améliorer le contrôle de l'épaisseur gravée et de réduire les dommages surfaciques, elle présente pour inconvénient d'induire une durée importante de mise en œuvre, durée qui n'est pas compatible avec les exigences industrielles en termes de productivité.

Un objet de la présente invention est donc de proposer une solution, permettant de graver une couche à base de matériau III-N tel que le GaN avec précision et tout en limitant voire en supprimant les inconvénients des solutions connues. En particulier, il serait avantageux de proposer une solution permettant de graver une couche à base de matériau III-N avec précision et avec une durée réduite par rapport aux solutions connues de gravure cycliques.

Les autres objets, caractéristiques et avantages de la présente invention apparaîtront à l'examen de la description suivante et des dessins d'accompagnement. Il est entendu que d'autres avantages peuvent être incorporés.

### RÉSUMÉ

Pour atteindre cet objectif, selon un mode de réalisation on prévoit un procédé de gravure d'au moins une couche à base d'un matériau III-V, le procédé comprenant au moins :
- fournir au moins une couche à base d'un matériau III-V présentant une face avant,
- au moins un cycle comprenant au moins les étapes suivantes:
   ∘ modifier, par implantation d'ions à base d'hydrogène (H) et/ou d'hélium (He), une partie au moins de l'épaisseur (e100) de ladite couche pour former dans ladite couche au moins une portion modifiée s'étendant depuis la face avant, l'implantation étant effectuée à partir d'un plasma,
   ∘ oxyder une partie au moins de la portion modifiée en exposant ladite couche à un plasma à base d'oxygène, pour définir dans ladite couche au moins une portion oxydée et au moins une portion non oxydée,
   ∘ après l'étape de modification et l'étape d'oxydation, graver l'au moins une portion oxydée sélectivement à l'au moins une portion non oxydée.

Ainsi, l'implantation d'ions à base d'ions légers d'hydrogène (H) et/ou d'hélium permet de modifier la couche à base du matériau III-V sur une épaisseur relativement importante, typiquement sur une épaisseur supérieure à 4 nanomètres (10⁻⁹ mètres).

L'oxydation s'effectue ensuite de manière privilégiée et beaucoup plus rapide sur les portions modifiées par implantation. Surtout, l'oxydation s'effectue sur une profondeur bien plus importante que dans un procédé qui ne prévoit pas d'étape de modification par implantation d'ions légers. De préférence, toute l'épaisseur des portions modifiées par implantation se trouve oxydée.

En effet, il a été remarqué qu'avec les procédés connus de gravure cyclique, le plasma est réalisé sans bombardement ionique ou avec un très faible bombardement pour ne pas pulvériser et endommager la couche d'AlGaN. Ce faible bombardement oblige à ce que l'épaisseur de la couche oxydée soit très faible. Il est alors nécessaire de répéter un grand nombre de fois la procédure pour atteindre l'épaisseur souhaitée de GaN gravé. La durée du procédé est alors très longue.

La gravure permet de retirer les portions oxydées sélectivement aux portions non oxydées. La gravure s'arrête ou voit sa vitesse réduire très significativement lorsque tout l'oxyde est consommé. Cette gravure est ainsi autolimitante. Dans certaines conditions de gravure, la sélectivité de la gravure des portions oxydées vis-à-vis des portions non oxydées est infinie ou quasiment infinie.

Ce procédé permet de contrôler avec une grande précision la profondeur retirée du matériau III-V tout en retirant à chaque cycle une épaisseur importante. Pour une même épaisseur de matériau III-V à retirer, le procédé proposé permet de réduire considérablement la durée de mise en œuvre. La solution proposée améliore ainsi considérablement la productivité des procédés de gravure des couches à base de matériaux III-V.

Par ailleurs, la profondeur gravée est homogène sur toute la surface de la couche.

En outre, l'implantation d'ions légers et à l'aide d'un plasma permet de contrôler avec précision la profondeur implantée. Les zones mises à nu à l'issue de la gravure ne sont pas endommagées. Les dispositifs réalisés à partir de ces gravures présentent alors des performances améliorées.

L'implantation à partir d'un plasma permet de modifier la couche III-V, depuis sa face avant et de manière continue sur une profondeur contrôlée. Ainsi l'oxydation s'effectue également de manière continue depuis la face avant de ladite couche. Par ailleurs, l'implantation à partir d'un plasma permet d'obtenir une bonne homogénéité de la modification. L'oxydation sera ainsi contrôlée avec précision et sera également homogène sur toute la profondeur modifiée. La gravure qui s'ensuivra sera elle aussi contrôlée avec précision.

De préférence, l'ensemble de ces étapes est effectué dans un même réacteur de gravure. Cela permet de limiter le nombre d'étapes et de réduire considérablement la durée du procédé.

Un autre aspect concerne un procédé de réalisation d'un transistor comprenant les étapes suivantes :
- Fournir un empilement comprenant successivement au moins : un substrat, une couche à base d'un matériau III-N et un masque, ladite couche comprenant successivement une couche de GaN, une couche d'AIN et une couche d'AlGaN,
- Graver la couche à base du matériau III-N à travers le masque, en mettant en œuvre le procédé décrit ci-dessus, de sorte à former au moins trois tranchées au droit d'ouvertures formées par le masque,
- Remplir les tranchées pour définir dans les tranchées au moins une grille de transistor, une source et un drain.

Ce procédé permet de retirer avec précision toute l'épaisseur des couches d'AlGaN et d'AIN et en contrôlant la profondeur gravée dans la couche de GaN. Par ailleurs, le GaN mis à nu en fond de tranchée et qui est conservé n'est pas endommagé. On peut au besoin prévoir un recuit pour désorber des espèces éventuellement implantées dans le GaN, tel que de l'hélium. Le procédé proposé permet ainsi d'améliorer les performances du transistor obtenu. Par ailleurs ce procédé est fiable, aisément reproductible et peu coûteux. Il est en outre compatible avec les contraintes de productivité industrielle.

Un autre aspect de la description concerne un transistor comprenant:
- un empilement comprenant successivement au moins : un substrat, une couche à base d'un matériau III-N et un masque, la couche à base dun matériau III-N comprenant successivement une couche de GaN, une couche d'AIN et une couche d'AlGaN,
une source, un drain et une grille s'étendant chacun au travers de toute l'épaisseur de la couche d'AIN et de toute l'épaisseur de la couche d'AlGaN pour déboucher dans la couche de GaN.

Un autre aspect concerne un dispositif microélectronique obtenu par un procédé mettant en œuvre le procédé ci-dessus de gravure d'une couche à base d'un matériau III-N. Par dispositif microélectronique, on entend tout type de dispositif réalisé avec des moyens de la microélectronique. Ces dispositifs englobent notamment en plus des dispositifs à finalité purement électronique, des dispositifs micromécaniques ou électromécaniques (MEMS, NEMS...), ainsi que des dispositifs optiques ou optoélectroniques (MOEMS...).

### BRÈVE DESCRIPTION DES FIGURES

Les buts, objets, ainsi que les caractéristiques et avantages de l'invention ressortiront mieux de la description détaillée d'un mode de réalisation de cette dernière qui est illustré par les dessins d'accompagnement suivants dans lesquels :
Les figures 1A à 1E illustrent de manière schématique les étapes principales d'un procédé selon un premier mode de réalisation de la présente invention.
La figure 2 représente, sous forme d'un ordinogramme, les étapes principales d'un procédé selon le mode de réalisation illustré en figure 1.
La figure 3 est une photo du résultat obtenu après mise en œuvre d'un procédé selon l'état de la technique.
La figure 4 est une photo du résultat obtenu après mise en œuvre d'un exemple de procédé selon l'invention.
La figure 5 représente, sous forme d'un ordinogramme, les étapes principales d'un procédé selon un mode de réalisation alternatif.
Les figures 6A à 6C illustrent de manière schématique certaines étapes appliqué à une structure dans laquelle la couche de matériau III-N est un empilement de plusieurs couches.
La figure 7 est une illustration schématique du dispositif microélectronique obtenu après remplissage des ouvertures réalisée par gravure dans la couche de matériau III-N représentée en figure 6A à 6C.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier les épaisseurs relatives des différentes couches ne sont pas représentatives de la réalité.

### DESCRIPTION DÉTAILLÉE

Avant d'entamer une revue détaillée de modes de réalisation de l'invention, sont énoncées ci-après des caractéristiques optionnelles qui peuvent éventuellement être utilisées en association ou alternativement.

De préférence, l'étape de modification, l'étape d'oxydation et l'étape de gravure étant de préférence effectuées dans un même réacteur de gravure.

Selon un exemple, l'étape de gravure est effectuée à l'aide d'un plasma. Selon un exemple, cette étape de gravure est effectuée à l'aide d'un plasma à base de trichlorure de bore (BCl3).

Selon un exemple, avant d'effectuer ledit cycle, la face avant de la couche à base d'un matériau III-N est surmontée d'un masque. Selon un exemple, le masque est à base de nitrure et de préférence à base de nitrure de silicium (SixNy, x et y étant des entiers non nuls).

Selon un exemple, la modification par implantation est effectuée de sorte à ce que la portion modifiée s'étende depuis la face avant et sur une profondeur e110 supérieure à 2 nm (10⁻⁹ mètres), de préférence supérieure ou égale à 4 nm (10⁻⁹ mètres), avec de préférence 5nm < e110 < 20 nm. Cette profondeur permet de contrôler avec une grande précision la profondeur retirée à chaque cycle tout en permettant de retirer beaucoup de matière à chaque cycle. La vitesse d'exécution du procédé en est augmentée.

Selon un exemple, l'étape d'oxydation est effectuée de sorte à oxyder au moins 80% de la profondeur de la portion modifiée par implantation d'ions à base d'hydrogène et/ou d'hélium. Selon un exemple, l'étape d'oxydation est effectuée de sorte à oxyder toute la portion modifiée. Ainsi, dans cet exemple 100% de la profondeur de la portion modifiée par implantation d'ions à base d'hydrogène et/ou d'hélium se trouve oxydée. Ainsi l'épaisseur oxydée à chaque cycle est significativement supérieure à l'épaisseur qui serait oxydée en mettant en œuvre un procédé ne comprenant pas d'étape de modification par implantation d'ions légers. La vitesse d'exécution du procédé en est encore augmentée.

Selon un exemple, ladite couche est destinée à former une couche active d'un transistor.

Selon un exemple, le matériau III-V est un matériau III-N. Selon un exemple, le matériau III-N est un matériau à base de nitrure de gallium (GaN).

Selon un exemple, le matériau III-N est pris parmi : le GaN, l'AlGaN, l'InGaN, l'AlInGaN, l'AIN.

Selon un exemple, le procédé comprend, après l'au moins un cycle, une étape de recuit effectuée de sorte à désorber une partie au moins des ions à base d'hydrogène (H) et/ou d'hélium (He) qui demeuraient dans ladite couche à l'issue de l'au moins un cycle.

Selon un exemple, le procédé comprend une pluralité de cycles et comprend, uniquement après le dernier cycle, une étape de recuit effectuée de sorte à désorber une partie au moins des ions à base d'hydrogène (H) et/ou d'hélium (He). Selon un exemple, le recuit est effectué à une température d'au moins 500°C. De préférence, le recuit est effectué une température d'au moins 600°C. De préférence, le recuit effectuée température inférieure à 900°C. De préférence, le recuit est effectué pendant une durée d'au moins une minute et de préférence de mois 10 minutes. De préférence, le recuit est effectué pendant une durée inférieure à 45 minutes. De préférence, le recuit est effectué pendant une durée comprise entre 10 minutes et 30 minutes.

Ces conditions de recuit ont permis d'améliorer dans une proportion inattendue les propriétés des matériaux gravés.

Selon un exemple, le procédé comprend une pluralité de cycles, le nombre de cycles étant de préférence supérieur à 8, de préférence supérieur à 10 et de préférence compris entre 8 et 40.

Selon un exemple, les étapes de modification et d'oxydation sont effectuées à l'aide d'un même plasma comprenant lesdits ions à base d'H et/ou d'He et l'oxygène. Ainsi les étapes de modification et d'oxydation sont effectuées simultanément. La vitesse d'exécution du procédé en est encore augmentée.

Il est précisé que dans le cadre de la présente invention, l'épaisseur d'une couche se mesure selon une direction perpendiculaire à la surface selon laquelle cette couche présente son extension maximale. Sur les figures, l'épaisseur est prise selon la verticale. De même lorsqu'on indique qu'un élément est situé au droit ou à l'aplomb d'un autre élément, cela signifie que ces deux éléments sont situés tous deux sur une même ligne perpendiculaire au plan principal d'extension de la couche, soit sur une même ligne orientée verticalement sur les figures.

Un matériau III-N est un matériau comprenant au moins un élément de la colonne III et au moins de l'azote (N). De même, un matériau III-V est un matériau comprenant au moins un élément de la colonne III et au moins un élément de la colonne V.

On entend par un substrat, un film, une couche, « à base » d'un matériau A, un substrat, un film, une couche comprenant ce matériau A uniquement ou ce matériau A et éventuellement d'autres matériaux. Ainsi, dans la présente description, une couche à base d'un matériau III-N peut être une couche constituée exclusivement de matériau III-N ou une couche comportant un matériau III-N et d'autres éléments.

Selon un exemple, dans le cadre de la présente invention une couche à base d'un matériau III-N est un matériau à base de GaN ou d'AIN.

Une couche à base de GaN peut être une couche constituée exclusivement de GaN. Alternativement elle peut être constituée de GaN et d'un ou plusieurs éléments de la colonne III ou de la colonne V du tableau périodique des éléments voire d'autres éléments, qui sont par exemple présents de manière involontaire et qui peuvent éventuellement provenir d'implantation non souhaitées. Typiquement il peut s'agir d'une couche d'AlGaN, d'InGaN ou d'AlInGaN.

Selon un exemple la couche de matériau III-N est dopée. Le dopage peut être réalisé avec l'une au moins des espèces suivantes : Mg, Si, P, O, Ca, C.

Une couche peut par ailleurs être composée de plusieurs sous-couches d'un même matériau ou de matériaux différents. Ainsi, une couche à base d'un matériau III-N peut comprendre un empilement de plusieurs couches à base d'un matériau III-N. En particulier, une couche à base de GaN peut être un empilement de couches à base de GaN. L'empilement peut par exemple comprendre une couche d'AlGaN située sur, de préférence directement au contact d'une couche faite de GaN.

Dans la présente description, un matériau à base de SixNy avec x et y entiers non nuls peut, par exemple, être l'un des matériaux suivants : SiN, Si₃N₄, SiOCN, SiCBN.

Le mot « diélectrique » qualifie un matériau dont la conductivité électrique est suffisamment faible dans l'application donnée pour servir d'isolant électrique.

Il est précisé que, dans le cadre de la présente invention, les termes « sur », « surmonte », « recouvre », « sous-jacent », en « vis-à-vis » et leurs équivalents ne signifient pas forcément « au contact de ». Ainsi par exemple, le dépôt, le report, le collage, l'assemblage ou l'application d'une première couche sur une deuxième couche, ne signifie pas obligatoirement que les deux couches sont directement au contact l'une de l'autre, mais signifie que la première couche recouvre au moins partiellement la deuxième couche en étant soit directement à son contact, soit en étant séparée d'elle par au moins une autre couche ou au moins un autre élément.

Le terme « étape » ne signifie pas obligatoirement que les actions menées durant une étape soient simultanées ou immédiatement successives. Certaines actions d'une première étape peuvent notamment être suivies d'actions liées à une étape différente, et d'autres actions de la première étape peuvent être reprises ensuite. Ainsi, le terme étape ne s'entend pas forcément d'actions unitaires et inséparables dans le temps et dans l'enchaînement des phases du procédé.

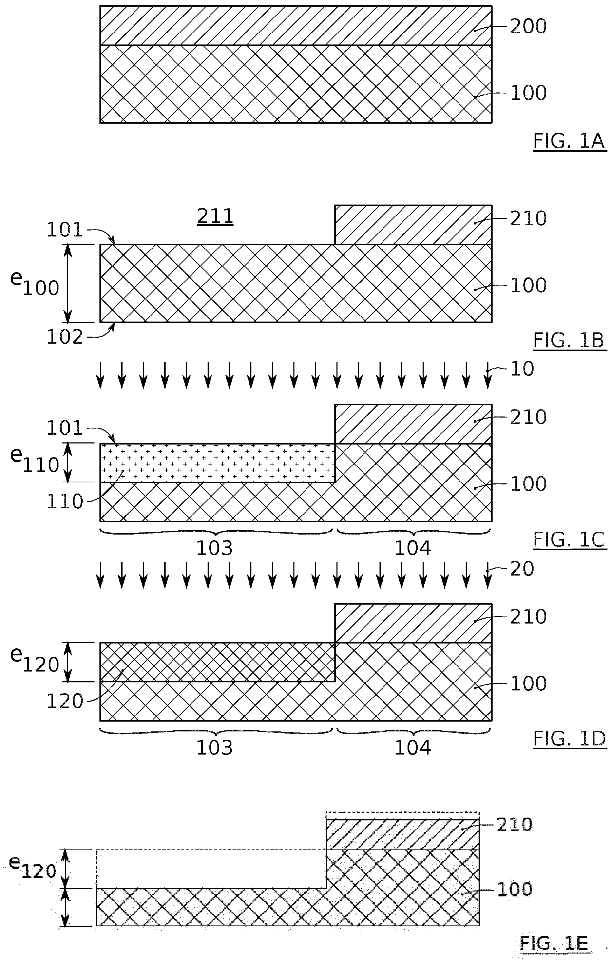

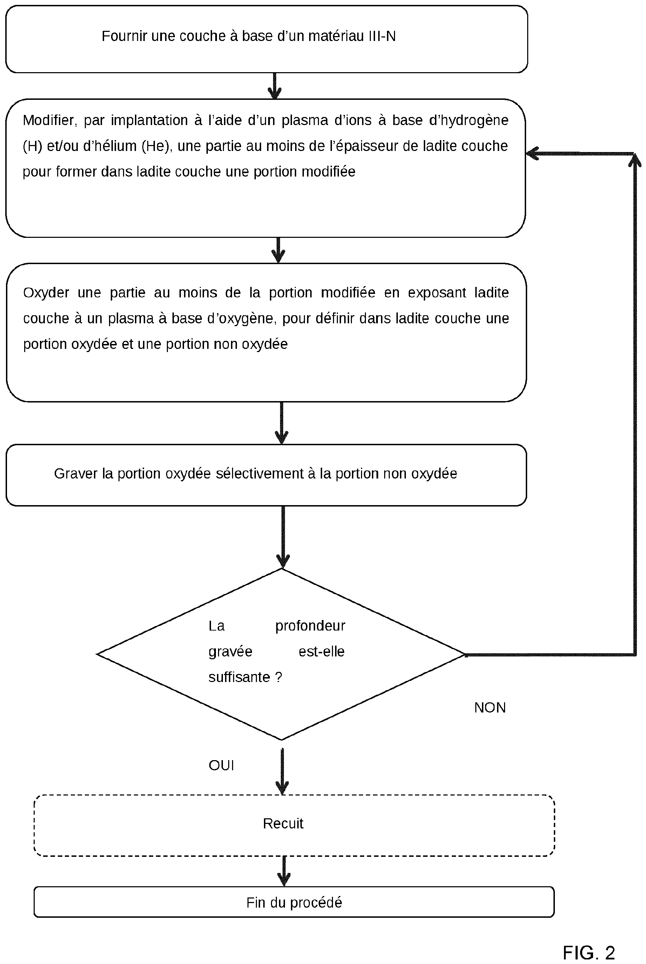

Un premier mode de réalisation va maintenant être décrit en détail en référence aux **figures 1A à 1E** **et** **2**.

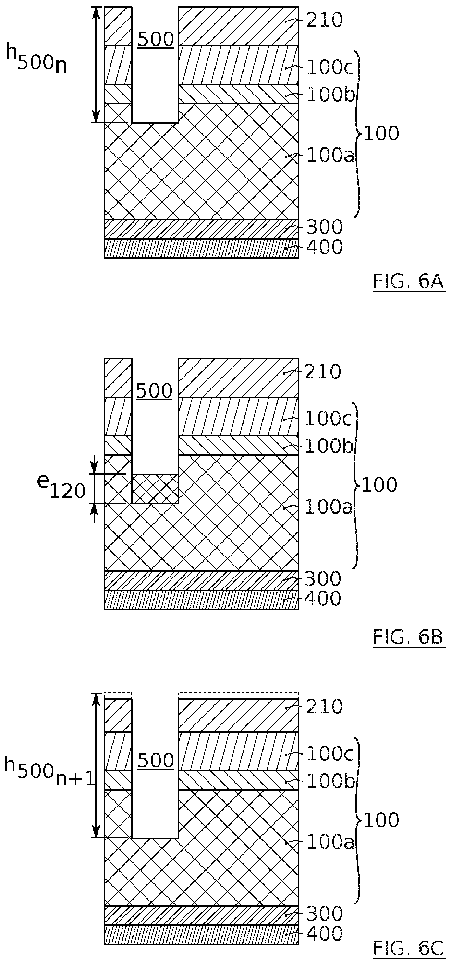

Une étape préliminaire consiste à fournir une couche 100 par exemple à base d'au moins un matériau III-V, de préférence à base d'au moins un matériau III-N. Typiquement, ce matériau est à base de GaN. Ce procédé s'applique également à d'autres matériaux que les matériaux III-N ou III-V. Cette couche 100 peut être formée d'une unique couche. Elle peut également être formée d'un empilement de couches 100a, 100b, 100c comme cela sera décrit en référence aux figures 6A à 7. La couche 100 peut reposer sur un substrat, typiquement un substrat de support ou de croissance (non illustré en figures 1A à 1E). Une ou des couches intermédiaires peuvent être disposées entre le substrat et une face arrière 102 de la couche 100. Selon un mode de réalisation, cette couche 100 est destinée à former la couche active d'un transistor.

Par ailleurs, afin de graver certaines zones seulement de la couche 100, on peut prévoir de former un masque 210 surmontant la couche 100. La présence de ce masque 210 n'est cependant pas obligatoire pour mettre en œuvre le procédé de gravure décrit ci-dessous.

Selon un exemple, le masque 210 est disposé directement au contact d'une face avant 101 de la couche 100. Le masque 210 est par exemple formé par lithographie d'une couche 200 déposée ou reportée sur la couche 100. De préférence, le masque 210 est un masque dur. Il est par exemple formé à base de SixNy avec x et y entiers non nuls. On peut par exemple citer comme exemple les matériaux suivants pour former le masque dur 210 : SiN, Si₃N₄, SiOCN, SiCBN. Le masque 210 présente des ouvertures 211 comme illustré en figure 1B.

On effectue ensuite au moins un cycle dont les étapes vont être décrites ci-dessous.

### 1^{ère} Etape du cycle : Modification de la couche à base de matériau III-N

Une première étape du cycle vise à modifier la couche 100 en y implantant des ions légers à l'aide d'un plasma. Cette étape est illustrée en figure 1C.

Les paramètres du plasma, en particulier la nature des ions, l'énergie des ions et la dose implantée sont réglées de sorte à modifier la couche 100 sans pour autant la graver ni même la pulvériser. Ainsi, il s'agit essentiellement ou principalement d'une modification chimique, l'ajout d'ions dans cette couche 100 changeant sa sélectivité. Ainsi, les portions modifiées 110 de cette couche 100 s'oxyderont beaucoup plus facilement que les portions non modifiées.

De préférence, cette implantation 10 d'ions est réalisée pleine plaque, au travers du masque 210 s'il est présent.

L'implantation 10 est réglée de sorte à ce que les ions soient implantés selon une direction privilégiée, perpendiculaire au plan dans lequel s'étend principalement la couche 100.

Ainsi, au droit 103 des ouvertures 211 du masque 210 la couche 100 est modifiée sur une profondeur e110. Au droit 104 des portions non ouvertes du masque 210, la couche 100 n'est pas modifiée par l'implantation.

De préférence, la profondeur d'implantation e110, et donc l'épaisseur des portions modifiées 110 est supérieure à 4 nm et de préférence supérieure à 5 nm. De préférence, 5nm<e110<20nm. De préférence, 10nm <e110<20nm. Sur des épaisseurs inférieures à 20 nm il est en effet aisé de maîtriser avec précision la profondeur d'implantation à l'aide d'un plasma d'ions légers et d'obtenir une modification continue voire homogène sur toute la profondeur implantée.

Typiquement, cette modification comprend l'implantation d'ions à base d'hydrogène (H, H⁺, H₂⁺, H₃⁺, etc....). Selon un autre mode de réalisation, les ions implantés sont des ions d'hélium (He) ou un mélange d'ions d'hélium et d'hydrogène (H/He). Ces ions peuvent provenir par exemple des gaz suivants introduits dans le réacteur : H₂, HBr ; NH₃.

Cette implantation 10 est par exemple réalisée dans un réacteur de gravure, par exemple un réacteur plasma à couplage inductif ICP.

Des exemples non limitatifs de paramètres utilisés pour cette implantation 10 seront décrits par la suite.

### 2^{ème} Etape du cycle : Oxydation des portions modifiées

Une deuxième étape du cycle vise à oxyder les portions modifiées 110 par l'implantation 10. Cette étape est illustrée en figure 1D.

Cette oxydation 20 est effectuée de sorte à oxyder les portions modifiées 110 préférentiellement aux portions non modifiées de la couche 100. De préférence, seules les portions modifiées 110 sont oxydées.

De préférence, cette oxydation 20 est configurée de sorte à oxyder les portions modifiées 110 sur plus de la moitié de leur profondeur e110, de préférence sur au moins 80% de leur profondeur e110 et encore plus préférentiellement sur toute leur profondeur e110. La figure 1D illustre le cas où toute l'épaisseur e110 de la portion modifiée 110 est oxydée. Cela permet de retirer de manière parfaitement contrôlée une épaisseur importante du matériau à graver.

À l'issue de l'oxydation 20, la couche 100 présente ainsi des portions oxydées 120 et des portions non oxydées. De préférence, les portions oxydées 120 sont situées au droit 103 des ouvertures 211 du masque 210. Les portions non oxydées sont situées au droit 104 des zones non ouvertes du masque 210.

Cette oxydation 20 est effectuée à l'aide d'un plasma à base d'oxygène. De préférence, cette oxydation 20 réalisée dans le même réacteur que celui servant à l'implantation 10.

Des exemples non limitatifs de paramètres utilisés pour cette oxydation 20 seront décrits par la suite.

### 3^{ème} Etape du cycle : Gravure des portions modifiées

Une troisième étape du cycle vise à graver sélectivement les portions modifiées 120 vis-à-vis des portions non modifiées de la couche 100. Cette étape est illustrée en figure 1C.

Selon un exemple, cette gravure sélective est effectuée à partir d'un plasma à base de trichlorure de bore (BCl₃).

Les paramètres de la gravure sont de préférence réglés de sorte à retirer toute l'épaisseur e120 des portions modifiées 120.

Ainsi, seules les portions de la couche 100 située au droit 103 des ouvertures 211 du masque 210 sont gravées.

Ce cycle d'étapes comprenant au moins l'implantation 10, l'oxydation 20 et la gravure peut être répété plusieurs fois jusqu'à ce que l'épaisseur e120 totale gravée corresponde à la profondeur que l'on souhaite retirer dans la couche 100.

Cette répétition du cycle est illustrée dans l'ordinogramme de la figure 2.

Par exemple, pour graver entre 20 et 110 nm de la couche 100, on effectue entre 5 et 28 cycles.

Avec le procédé décrit ci-dessus, on obtient une vitesse de gravure de la couche 100 significativement augmentée tout en conservant un contrôle très précis de la profondeur gravée. En effet, la gravure s'arrête lorsque tout l'oxyde est consommé.

En outre, ce procédé présente une bonne sélectivité de la gravure de la couche 100 par rapport au masque 210. Le masque 210 se trouve gravé mais à une vitesse moindre que la couche 100. Ainsi l'épaisseur gravée dans le masque 210 est inférieure à l'épaisseur e120 gravée dans la couche 100, comme cela est illustré en figure 1E.

Avec des cycles d'oxydation puis gravure par une solution de BCl₃, le SiN se grave à une vitesse de 0.8 nm/cycle contre 1.6nm/cycle pour la couche 100 en GaN. Avec des cycles comprenant chacun une implantation par des espèces He puis une oxydation puis ensuite gravure par une solution de BCl₃, la gravure du SiN est aussi accélérée. Il est donc nécessaire de dimensionner en conséquence l'épaisseur initiale du masque 210.

De préférence, chacune des étapes du cycle est effectuée dans le même réacteur de gravure. Cela permet de réduire le nombre d'étapes et de réduire la durée totale du procédé. Par ailleurs, cela évite d'avoir à retirer la couche 100 d'un équipement ce qui entraînerait un risque plus élevé de contamination.

De manière optionnelle on effectue un recuit. Ce recuit vise notamment à provoquer une désorption des ions légers à base d'hélium ou d'hydrogène. Cela permet d'améliorer les performances du dispositif comprenant la couche 100 gravée et en particulier la résistance de couche Rₛₕₑₑₜ. De préférence, ce recuit est effectué une seule fois, à l'issue du dernier cycle.

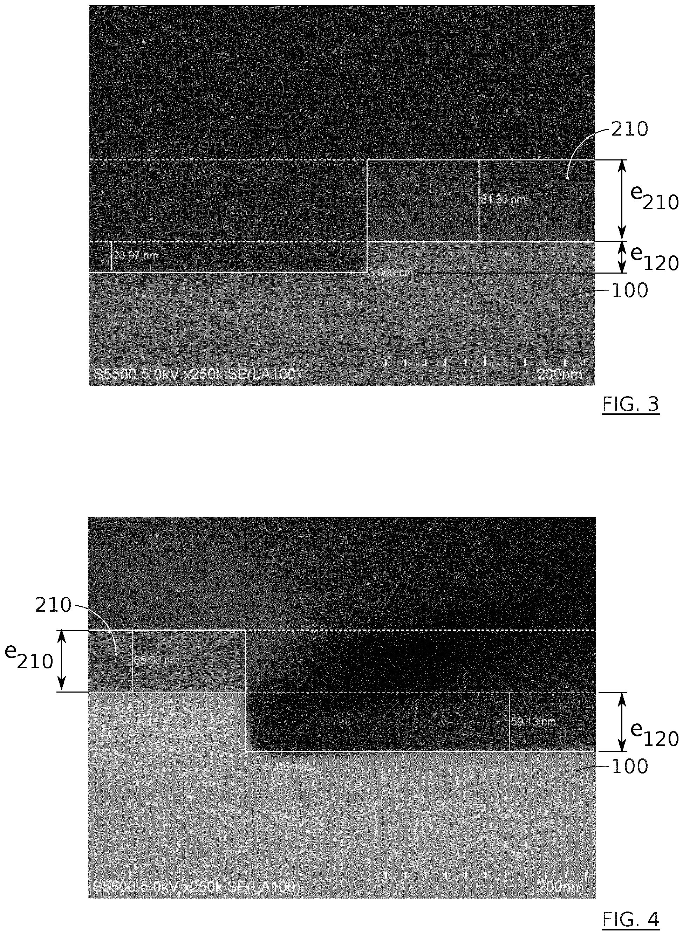

Les figures 3 et 4 sont des photos, en coupe, montrant la gravure d'une couche de GaN 100, surmonté d'un masque dur 210 de SiN.

La figure 3 illustre le résultat obtenu en mettant en œuvre un procédé de gravure cyclique comprenant pour chaque cycle une oxydation et une gravure sans implantation préalable à l'oxydation, la gravure étant effectuée à l'aide d'une solution à base de BCl₃. Au terme de 15 cycles, la couche 100 se trouve gravée sur une profondeur e120 de 29 nm. Au cours de chacun de ces cycles, la durée de l'oxydation est de 30 secondes et la durée de la gravure est de 15 secondes.

La figure 4 illustre le résultat obtenu en mettant en œuvre un procédé de gravure cyclique, tel que celui décrit ci-dessus. Au terme de 15 cycles comprenant chacun une implantation d'ions légers de type hélium, suivie d'une oxydation 20 par un plasma d'oxygène puis d'une gravure à l'aide d'une solution à base de BCl₃, la couche 100 se trouve gravée sur une profondeur e120 de 59 nm. Au cours de chacun de ces cycles, la durée de l'implantation 10 est de 30 secondes, la durée de l'oxydation 20 est de 30 secondes et la durée de la gravure est de 15 secondes. Dans cet exemple la tension de polarisation (bias voltage) utilisée lors de l'implantation est de 33V.

En utilisant les mêmes conditions mais avec une tension de polarisation de 7V et une durée d'implantation de 15V, on obtient une profondeur de gravure de 41 nm.

Avec un procédé classique dans lequel chaque cycle comprend une oxydation puis une gravure avec une solution de BCl₃: la profondeur de gravure est de 1.6nm/cycle. Chaque cycle comprend les étapes suivantes : 10s de stabilisation (également désignée purge), 30s d'injection de O2, 10s de stabilisation, 15s d'injection de BCl₃. La durée totale est de 65s et permet d'obtenir une vitesse de gravure de 1.5nm/min.

Avec un procédé selon l'invention incluant une injection de He pendant 30s, on obtient une vitesse de gravure de 4nm/cycle. Chaque cycle comprend les étapes suivantes : 10s de stabilisation, 30s d'injection He, 10s de stabilisation, 30s d'injection O2, 10s de stabilisation, 15s d'injection BCl₃. La durée totale est de 105s et permet d'obtenir une vitesse de gravure de 2,3nm/min.

Avec un procédé selon l'invention incluant une injection d'He pendant 15s, on obtient une vitesse de gravure de 2,7 nm/cycle. Chaque cycle comprend les étapes suivantes: 10s de stabilisation, 15s d'injection He, 10s de stabilisation, 30s d'injection O2, 10s de stabilisation, 15s d'injection BCl₃. La durée totale est de 90s et permet d'obtenir une vitesse de gravure de 1,8nm/min.

Au regard des exemples ci-dessus, il ressort clairement que le procédé selon l'invention permet d'augmenter la vitesse de gravure. L'amélioration la plus importante en termes de vitesse de gravure concerne le mode de réalisation dans lequel l'He est injecté pendant pendant 30s.

Si on ne compte pas les étapes de stabilisation, les différences de vitesse de gravure sont encore accentuées. Avec un procédé classique sans implantation préalable oxydation la vitesse de gravure est de 2.1 nm/min. Avec un procédé selon l'invention la vitesse de gravure est de 3.2/min avec injection d'He pendant 30 secondes et est de 2.7/min avec injection d'He pendant 15 secondes.

À chaque cycle, la profondeur gravée est bien plus importante dans le cas du procédé selon l'invention que dans le cas d'un procédé ne comprenant pas d'étape d'implantation préalable. En dépit de l'adjonction de l'étape d'implantation 10, la vitesse de gravure est considérablement augmentée.

Ainsi, pour une même profondeur gravée, l'invention permet de réduire très fortement le nombre de cycles et le temps du procédé. Par ailleurs, le nombre de cycles étant réduit, certaines étapes sont supprimées, telles que des étapes de purge du réacteur ce qui permet de réduire encore la durée totale du procédé.

L'étape d'implantation 10 et l'étape d'oxydation 20 peuvent, à chaque cycle, être effectuées successivement. C'est ce mode de réalisation qui est illustrée en figure 1C et 1D et en figure 2. Dans ce mode de réalisation, on peut par exemple prévoir d'introduire dans un réacteur dans un premier temps des premiers gaz permettant l'implantation 10 des ions légers puis, dans un deuxième temps de stopper l'introduction de ces premiers gaz et d'introduire des deuxièmes gaz permettant l'oxydation 20.

Ce mode de réalisation présente des avantages très significatifs. En effet, l'implantation d'ions à base d'hydrogène et/ou d'hélium, réalisée avant l'étape d'oxydation, permet d'adapter les paramètres de l'implantation de sorte à obtenir une profondeur d'implantation importante ainsi qu'un bon contrôle des dimensions critiques et du profil de la zone à graver. Typiquement, on peut augmenter l'énergie des ions pour qu'ils s'implantent sur une profondeur importante sans risquer de pulvériser la couche à graver. Par exemple, on pourra prévoir une tension ou puissance de polarisation (bias) importante pour obtenir une profondeur d'implantation e110 supérieure à 3 nanomètres, de préférence supérieure ou égale à 4 nanomètres et de préférence comprise entre 5 et 20 nm voire 100 nanomètres. Avec une telle tension ou puissance de polarisation, la présence d'ions oxygène provoquerait une pulvérisation de la couche à gravée. Cette pulvérisation viendrait dégrader le profil du fond de la région implantée. Lorsque cette région implantée débouche sur une couche sous-jacente où est située à proximité de cette couche sous-jacente, la pulvérisation pourrait dégrader cette couche sous-jacente. Par ailleurs, cette pulvérisation viendrait modifier le profil, des flancs de la région à graver. En effet, cette pulvérisation du matériau gravé modifierait l'état de surface des flancs. Par ailleurs, cette pulvérisation engendrerait un redépôt de matière sur les flancs et/ou sur le masque dur, perturbant de ce fait le contrôle du profil.

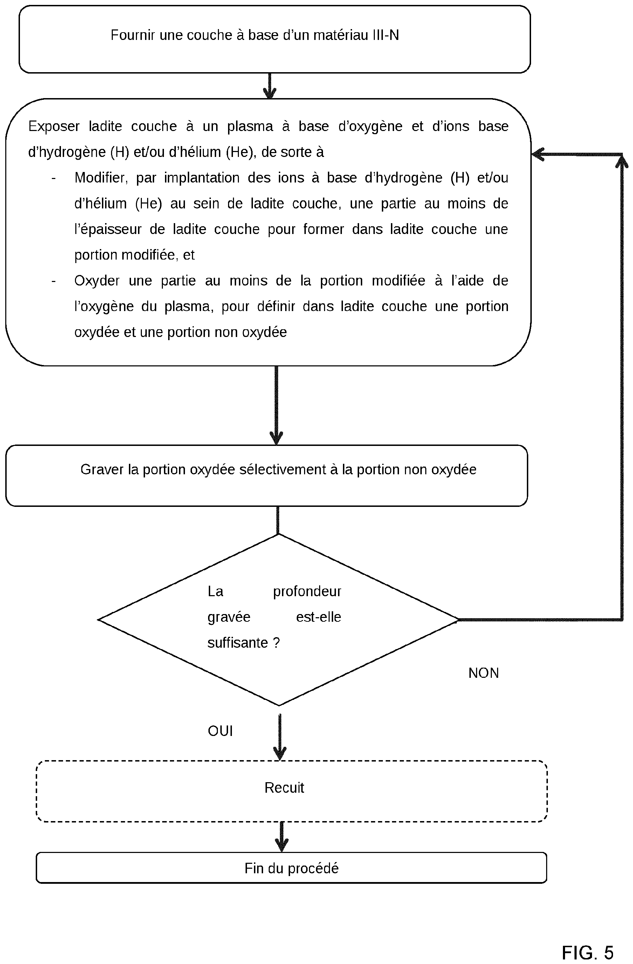

Selon un mode de réalisation alternatif, illustré en figure 5, l'implantation 10 et l'oxydation 20 sont effectuées à partir d'un même plasma. Ainsi, le réacteur comprend en sons sein simultanément les premiers gaz permettant l'implantation 10 des ions légers ainsi que les deuxièmes gaz permettant l'oxydation 20. Par exemple, on introduit simultanément ces premiers et deuxièmes gaz. Alors que les ions légers s'implantent dans les portions 110 de la couche 100, l'oxydation a lieu de manière privilégiée sur ces portions 110.

Le procédé décrit ci-dessus présente également des avantages concernant la résistance de couche Rₛₕₑₑₜ.

En effet il s'avère que l'empilement de couche III-V, en particulier l'empilement formé de la superposition d'une couche d'AlGaN et d'une couche GaN (avec éventuellement une couche d'AIN), présente un canal d'électrons ayant une résistance Rₛₕₑₑₜ₁ à l'issue du procédé décrit ci-dessus significativement inférieure à la résistance Rₛₕₑₑₜ₂ du canal d'électrons pour cette même structure obtenu à l'issue d'un procédé de gravure cyclique sans implantation préalable à l'oxydation. Avant recuit, Rₛₕₑₑₜ₁ est plus élevé que Rₛₕₑₑₜ₂. Le recuit permet d'améliorer Rₛₕₑₑₜ₁ dans une proportion toute à fait surprenante dans le cas du procédé selon l'invention. En effet non seulement le recuit permet d'améliorer Rₛₕₑₑₜ₁ de sorte à atteindre Rₛₕₑₑₜ₂ mais en plus il permet de le dépasser significativement.

Typiquement, avec le procédé décrit ci-dessus dans lequel la tension de polarisation lors de l'injection He est de 7V et dans lequel He est injecté pendant 15 secondes Rₛₕₑₑₜ₁ = 1,41 alors que Rₛₕₑₑₜ₂ = 2,04. Ces valeurs de résistance Rₛₕₑₑₜ₁ sont mesurées après recuit. Ces valeurs de résistance Rₛₕₑₑₜ sont relatives à une valeur d'une référence. Une valeur de 1 signifie que l'on n'a aucune dégradation. Une valeur supérieure à 1 signifie que l'on a une augmentation de la résistance du canal d'électrons et donc une dégradation des performances du transistor comprenant ce canal.

On rappellera que la résistance de couche, habituellement désignée par Rₛₕₑₑₜ s'exprime en Ω/ □ ou Ω.m. La résistance de couche Rₛₕₑₑₜ se mesure par exemple par la méthode connue des quatre pointes. Un exemple de cette méthode bien connue est par exemple décrit dans la demande de brevet EP3023799A1 publiée le 25 Mai 2016 et mentionnant comme inventeurs C. Leroux and J. LEHMANN.

En référence aux figures 6A à 7 un mode particulier de réalisation va maintenant être décrit.

Dans ce mode de réalisation, la couche 100 comprend une pluralité de couches à base chacune d'un matériau III-N. Dans cet exemple non limitatif, la couche 100 comprend, successivement disposées depuis un substrat 400, une couche 100a de GaN, une couche 100b d'AlN et une couche 100c d'AlGaN.

Dans cet exemple, une couche tampon 300 est disposée entre la couche 100 et le substrat 400.

La couche 100 est surmontée d'un masque 210, par exemple de SiN.

Un et de préférence n cycles d'implantation 10 / oxydation 20 / gravure sont mis en œuvre pour graver une tranchée 500 à travers une ouverture du masque 210, avec n supérieur ou égal à 2. Au terme de ces n cycles, cette tranchée s'étend au travers de toute l'épaisseur de la couche 100c et de la couche 100b et d'une partie seulement de l'épaisseur de la couche 100a. Cette tranchée 500 présente une profondeur h₅₀₀ₙ, telle que référencé en figure 6A.

La figure 6B illustre le résultat obtenu après l'étape d'implantation 10 à travers le masque 210 puis l'étape d'oxydation 20 d'un cycle additionnel n+1. La portion 120 de la couche 100 est oxydée sur une profondeur e120.

La figure 6C illustre le résultat obtenu après l'étape de gravure de ce cycle additionnel. La portion 120 se trouve retirée. La profondeur de la tranchée 500 augmente de e120 et devient h₅₀₀ₙ₊₁.

Cette tranchée 500 peut ensuite être remplie, par exemple d'un ou plusieurs matériaux, pour former des parties fonctionnelles d'un dispositif micro-électronique.

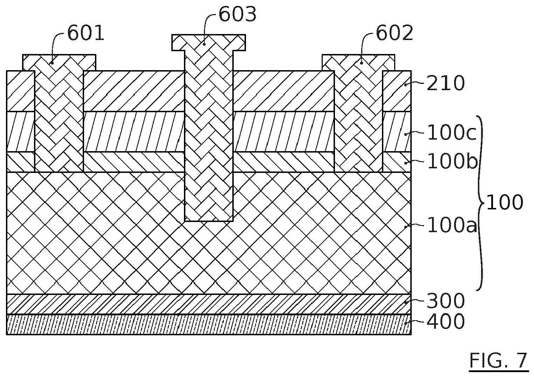

Comme illustré en figure 7, la tranchée 500 peut être remplie pour former une grille 603. D'autres tranchées, par exemple moins profondes et s'étendant uniquement à travers les couches 100b et 100c, peuvent être remplies pour former une source 601 et un drain 602. Dans cet exemple, la couche 100a forme la couche active d'un transistor.

Naturellement, une multitude d'autres dispositifs micro-électroniques peut être formée à partir de gravures de la couche 100.

Dans cet exemple, l'empilement est de type AlGaN/AlN/GaN. La couche d'AlN sert à améliorer le confinement des électrons dans le canal bi-dimensionnel. L'épaisseur de l'AlN est de préférence inférieure à 1nm. On peut aussi utiliser un empilement sans AlN.

### Exemple non limitatifs de réalisation

Un exemple non limitatif de réalisation va maintenant être décrit en détail.

Masque 210 : Le masque 210 est un masque dur en Nitrure de Silicium (SiN) déposé à une température supérieure à 500°C. Son épaisseur e210 est comprise entre 50 et 100nm. Elle est de préférence de 80nm

Couche 100 à base d'un matériau III-V: La couche 100 est formée d'un empilement comprenant une couche d'AlGaN surmontant une couche de GaN. Une couche d'AlN, de préférence fine, recouvre avantageusement la couche d'AlGaN. L'épaisseur à graver au sein de la couche 100 est comprise entre 20 et 110nm.

De préférence, l'étape de modification par implantation 10, l'étape d'oxydation 20 et l'étape de gravure sont réalisées dans un réacteur plasma à couplage inductif pour gravure ionique réactive (ICP-RIE).

### Etape de Modification :

Lors de l'étape de modification, le plasma est un plasma formé à partir d'au moins l'un des gaz suivants : H₂, He. Il peut également s'agir d'un plasma à base d'H, obtenu par exemple à partir des gaz NH₃ ou HBr. Dans ce cas il convient de réduire la tension de polarisation (bias voltage) pour éviter de pulvériser la couche AIN qui présente avantageusement une faible épaisseur.

De manière générale, il faut régler avec précaution la valeur de la tension de polarisation afin d'éviter une pulvérisation des couches implantées, que ces couches soient par exemple en AlGaN, en GaN ou en AlN. Cette précaution concernant la tension de polarisation doit être prise tout particulièrement avec des gaz de type NH₃ ou HBr mais également avec des espèces plus légères telles que H₂ ou He.

Le débit des espèces est compris entre 10sccm et 1000 sccm (centimètre cube par minute), de préférence entre 50 et 150sccm.

La pression est comprise entre 5mTorr et 100mTorr, de préférence entre 5mTorr et 50mTorr.

La puissance de la source est comprise entre 100W et 5000W et de préférence entre 500W et 1500W.

La tension de polarisation (bias voltage) est comprise entre 10V et 100V. Elle est de préférence comprise entre 20V et 50V. Ce paramètre conditionne la profondeur d'implantation des ions et permet d'ajuster la vitesse du procédé.

La température du substrat sur lequel repose la couche 100 est inférieure à 120°C. Une telle température permet de rendre plus efficace la modification par implantation 10.

La durée de cette étape de modification par implantation est comprise entre quelques secondes (typiquement 3 secondes) et plusieurs centaines de secondes. Cette durée est de préférence comprise entre 10s et 60s.

### Etape d'oxydation :

Pour l'étape d'oxydation, le plasma est un plasma d'oxygène. Le gaz introduit dans le réacteur est de l'O2.

Les espèces sont introduites dans le réacteur avec un débit compris entre 10sccm et 1000 sccm, de préférence entre 10 et 500sccm.

La pression est comprise entre 5mTorr et 100mTorr.

La puissance de la source est comprise entre 100W et 5000W, de préférence entre 500W et 1500W.

La tension de polarisation est comprise entre 0V et 50V. Elle est de préférence inférieure à 30V.

La température du substrat est inférieure à 120°C.

La durée de cette étape d'oxydation est comprise entre quelques secondes (typiquement 3 secondes) et plusieurs centaines de secondes. Cette durée est de préférence comprise entre 10s et 60s.

### Etape de retrait de la couche oxydée :

Pour l'étape gravure, le plasma est un plasma à base de BCl₃.

Les espèces sont introduites dans le réacteur avec un débit compris entre 10sccm et 1000 sccm, de préférence entre 10 et 60sccm.

La pression est comprise entre 5mTorr et 100mTorr.

La puissance de la source est comprise entre 100W et 5000W, de préférence entre 500W et 1500W.

La tension de polarisation est comprise entre 0V et 50V. Elle est de préférence inférieure à 30V.

La température du substrat est inférieure à 120°C.

La durée de cette étape d'oxydation est comprise entre quelques secondes (typiquement 3 secondes) et plusieurs centaines de secondes. Cette durée est de préférence comprise entre 10s et 60s.

Par exemple pour graver du GaN à une vitesse de 4nm/cycle on choisira les conditions indiquées dans le tableau suivant :

**Tableau 1**

| Ga z injecté | Puissance de la source | Puissan ce de polarisation | Pr ession | D ébit d'He | Dé bit d'O2 | Dé bit de BCl3 | Tensi on de polarisation | Tem ps |
|---|---|---|---|---|---|---|---|---|
| He | 1000W | 33W | 10 mT | 10 0 sccm | | | 30V | 30s |
| O₂ | 1000W | 20W | 10 mT | | 50 sccm | | 30V | 30s |
| BC I₃ | 1000W | 7W | 10 mT | | | 50 sccm | 10V | 15s |

La puissance de polarisation peut être augmentée afin d'augmenter la profondeur implantée.

On pourra, de préférence à l'issue du dernier cycle, effectuer une étape de recuit. Les conditions du recuit peuvent être les suivantes. Température de 600°C, durée de 20 minutes, sous atmosphère N2, à pression atmosphérique.

Au vu de la description qui précède il apparait clairement que le procédé proposé permet de retirer avec précision une épaisseur de couche de matériau III-N, sans altérer les portions restantes de cette couche ou une couche sous-jacente.

Le procédé proposé permet ainsi d'améliorer les performances des dispositifs à base de matériau III-V tels que les matériaux III-N comme ceux à base de GaN. Par ailleurs ce procédé est fiable, aisément reproductible et peu coûteux. Il est en outre compatible avec les contraintes de productivité industrielle.

L'invention n'est pas limitée aux modes de réalisations précédemment décrits et s'étend à tous les modes de réalisation couverts par les revendications.

## Revendications

1. Procédé de gravure d'au moins une couche (100) d'un matériau à base de nitrure de gallium (GaN) (100), le procédé comprenant au moins :
- fournir au moins une couche (100) à base de GaN présentant une face avant (101),
- au moins un cycle comprenant au moins les étapes successives suivantes:
∘ modifier, par implantation (10) d'ions à base d'hydrogène (H) et/ou d'hélium (He), une partie au moins de l'épaisseur (e100) de ladite couche (100) pour former dans ladite couche (100) au moins une portion modifiée (110) s'étendant depuis la face avant (101), l'implantation (10) étant effectuée à partir d'un plasma, la modification par implantation (10) est effectuée de sorte à ce que la portion modifiée (110) s'étende depuis la face avant (101) et sur une profondeur e110 supérieure à 3 nm (10⁻⁹ mètres),
∘ oxyder une partie au moins de la portion modifiée (110) en exposant ladite couche (100) à un plasma (20) à base d'oxygène, pour définir dans ladite couche (100) au moins une portion oxydée (120) et au moins une portion non oxydée,
∘ graver l'au moins une portion oxydée (120) sélectivement à l'au moins une portion non oxydée:

2. Procédé selon la revendication précédente dans lequel l'étape de gravure est effectuée à l'aide d'un plasma, l'étape de modification, l'étape d'oxydation et l'étape de gravure étant de préférence effectuées dans un même réacteur de gravure.

3. Procédé selon l'une quelconque des revendications précédentes dans lequel l'étape de gravure est effectuée à l'aide d'un plasma à base de trichlorure de bore (BCl3).

4. Procédé selon l'une quelconque des revendications précédentes dans lequel avant d'effectuer ledit cycle, la face avant (101) de la couche (100) à base de GaN est surmontée d'un masque (210).

5. Procédé selon la revendication précédente dans lequel le masque (210) est à base de nitrure et de préférence à base de nitrure de silicium SixNy, x et y étant des entiers non nuls.

6. Procédé selon l'une quelconque des revendications précédentes dans lequel la modification par implantation (10) est effectuée de sorte à ce que la portion modifiée (110) s'étende depuis la face avant (101) et sur une profondeur e110 supérieure à 4 nm (10⁻⁹ mètres).

7. Procédé selon l'une quelconque des revendications précédentes dans lequel la modification par implantation (10) est effectuée de sorte à ce que la portion modifiée (110) s'étende depuis la face avant (101) et sur une profondeur e110 telle que 5nm < e110 < 20 nm.

8. Procédé selon l'une quelconque des revendications précédentes dans lequel l'étape d'oxydation est effectuée de sorte à oxyder au moins 80% de la profondeur de la portion modifiée (110) par implantation d'ions à base d'hydrogène et/ou d'hélium.

9. Procédé selon l'une quelconque des revendications précédentes dans lequel l'étape d'oxydation est effectuée de sorte à oxyder toute la portion modifiée (110).

10. Procédé selon la revendication précédente dans lequel le matériau à base de GaN est pris parmi : le GaN, l'AlGaN, l'InGaN, l'AlInGaN.

11. Procédé selon l'une quelconque des revendications précédentes comprenant après l'au moins un cycle, une étape de recuit effectuée de sorte à désorber une partie au moins des ions à base d'hydrogène (H) et/ou d'hélium (He).

12. Procédé selon l'une quelconque des revendications précédentes comprenant une pluralité de cycles et comprenant, uniquement après le dernier cycle, une étape de recuit effectuée de sorte à désorber une partie au moins des ions à base d'hydrogène (H) et/ou d'hélium (He), le recuit étant effectué à une température d'au moins 500°C.

13. Procédé selon l'une quelconque des revendications précédentes comprenant une pluralité de cycles, le nombre de cycles étant de préférence supérieur à 8, de préférence supérieur à 10 et de préférence compris entre 8 et 40.

14. Procédé selon l'une quelconque des revendications précédentes dans lequel les étapes de modification et d'oxydation sont effectuées à l'aide d'un même plasma comprenant lesdits ions à base d'H et/ou d'He et l'oxygène.

15. Procédé de réalisation d'un transistor comprenant les étapes suivantes :
a. Fournir un empilement comprenant successivement au moins : un substrat (400), une couche (100) à base d'un matériau III-N et un masque (210), la couche (100) à base du matériau III-N comprenant successivement une couche (100a) de GaN, une couche (100b) d'AIN et une couche (100c) d'AlGaN au contact du masque (210),
b. Graver la couche (100) à base du matériau III-N à travers le masque (210), en mettant en œuvre le procédé selon l'une quelconque des revendications précédentes, de sorte à former au moins trois tranchées au droit d'ouvertures formées par le masque (210),
c. Remplir les tranchées pour définir au moins une grille (603) de transistor, une source (601) et un drain (602).
